# EUROPÄISCHE PATENTSCHRIFT

(11) **EP 3 194 995 B1**
(45) Veröffentlichungstag und Bekanntmachung des Hinweises auf die Patenterteilung: **10.06.2020**
(21) Anmeldenummer: 15766794.0
(22) Anmeldetag: 17.09.2015
(51) Int. Cl.: G01R 33/36

(54) **MESSVORRICHTUNG FÜR SCHWACHE ELEKTROMAGNETISCHE SIGNALE EINER PROBE BEI NIEDRIGEN FREQUENZEN NEBST VERFAHREN**
MEASURING APPARATUS FOR WEAK ELECTROMAGNETIC SIGNALS FROM A SAMPLE AT LOW FREQUENCIES, IN ADDITION TO A METHOD
DISPOSITIF DE MESURE DE SIGNAUX ÉLECTROMAGNÉTIQUES FAIBLES D'UN ÉCHANTILLON À BASSES FRÉQUENCES ET PROCÉDÉ

(30) Priorität: 19.09.2014 DE 102014218873
(43) Veröffentlichungstag der Anmeldung: 26.07.2017
(73) Patentinhaber: Forschungszentrum Jülich GmbH, 52425 Jülich (DE)
(72) Erfinder: APPELT, Stephan, 52070 Aachen (DE); SÜFKE, Martin, 50354 Hürth (DE); LIEBISCH, Bernd Alexander, 52064 Aachen (DE)
(74) Vertreter: Gille Hrabal
(86) Internationale Anmeldenummer: PCT/EP2015/071283
(87) Internationale Veröffentlichungsnummer: WO 2016/042057

(56) Entgegenhaltungen:
- US-A- 6 150 817
- US-A1- 2005 116 714
- US-A1- 2008 042 650
- US-A1- 2010 090 697
- MARTIN SUEFKE ET AL: "External high-quality-factor resonator tunes up nuclear magnetic resonance", NATURE PHYSICS, Bd. 11, Nr. 9, 6. Juli 2015 (2015-07-06), Seiten 767-771, XP055235363, GB ISSN: 1745-2473, DOI: 10.1038/nphys3382
- WOSIK J ET AL: "Cryogenic varactor-tuned 4-element array and cryostat for mu-MRI of trabecular bone in the distal tibia", PROCEEDINGS OF THE INTERNATIONAL SOCIETY FOR MAGNETIC RESONANCE IN MEDICINE, ISMRM, 16TH SCIENTIFIC MEETING AND EXHIBITION, TORONTO, CANADA, 3-9 MAY 2008, 19. April 2008 (2008-04-19), Seite 443, XP040603650,
- SILLERUD L O ET AL: "H NMR Detection of superparamagnetic nanoparticles at 1T using a microcoil and novel tuning circuit", JOURNAL OF MAGNETIC RESONANCE, ACADEMIC PRESS, ORLANDO, FL, US, Bd. 181, Nr. 2, 1. August 2006 (2006-08-01), Seiten 181-190, XP024919363, ISSN: 1090-7807, DOI: 10.1016/J.JMR.2006.04.005 [gefunden am 2006-08-01]

## Beschreibung

Die Erfindung betrifft eine Messvorrichtung für das Detektieren von schwachen elektromagnetischen Signalen einer Probe bei niedrigen Frequenzen und zwar insbesondere im Frequenzbereich von 1 kHz - 10 MHz sowie ein Messverfahren.

Das schwache elektromagnetische Signal einer Probe kann z.B. von präzedierenden Atomkernen (Kernspinresonanz, NMR), Elektronen (Elektronenspinresonanz, ESR) oder von oszillierenden magnetischen Nanopartikeln stammen, In solchen Fällen (Kernspins, Elektronen und magnetische Nanopartikel) werden die elektromagnetischen Signale zunächst mit einer Aufnehmerspule gemessen, die eine relativ schlechte Güte QI < 30 haben kann.

Im Fall der NMR oder ESR wird zur Messung eine Probe in ein homogenes magnetisches Feld B0 gebracht. Die Probe wird von einer Anregungsspule umgeben, welche ein hochfrequentes elektromagnetisches Wechselfeld senkrecht zum Hauptmagnetfeld erzeugt. Eine Messvorrichtung zur Messung von daraus resultierenden elektromagnetischen Signalen der Probe ist aus den Druckschriften US 2008/0231277 A1, US 7,405,567 B2 sowie US 8,115,488 82 bekannt.

Eine Messvorrichtung zur NMR Messung mit einem elektromagnetischen Schwingkreis mit einer Aufnehmerspule, einer Kapazität und einer Filterspule ist aus der Druckschrift WO 95/14240 bekannt.

Aus der Druckschrift US 2010/090697 A1 geht eine Messvorrichtung zur Detektion elektromagnetischer oder magnetischer Wechselfelder hervor. Diese Messvorrichtung umfasst einen elektromagnetischen Schwingkreis mit einer Aufnehmerspule, einer Kapazität und einer Filterspule.

Die Druckschrift DE 38 11 983 A1 offenbart eine sogenannte Doppeldrossel zur Unterdrückung von Mantelwellen.

Aufgabe der Erfindung ist die Schaffung einer Vorrichtung, mit der schwache elektromagnetische Signale einer Probe insbesondere im Frequenzbereich von 1 kHz - 40 MHz mit gutem Signal-Rausch-Verhältnis detektiert werden können.

Eine Messvorrichtung umfasst zur Lösung der Aufgabe die Merkmale des Anspruchs 1. Vorteilhafte Ausgestaltungen ergeben sich aus den abhängigen Ansprüchen.

Die Messvorrichtung umfasst einen elektromagnetischen Schwingkreis mit einer Aufnehmerspule, einer vorzugsweise abstimmbaren Kapazität und einer Filterspule. Filterspule und Kapazität weisen eine hohe Güte von wenigstens 100, vorteilhaft von wenigstens 200, besonders bevorzugt von wenigstens 500 auf. Alternativ oder ergänzend beträgt die Güte des Schwingkreises wenigstens 100, vorteilhaft von wenigstens 200, besonders bevorzugt von wenigstens 500. Das Messsignal steht dann an den beiden Enden der Filterspule mit gutem Signal - Rausch - Verhältnis zur Verfügung.

Die Filterspule weist eine geerdete Mittelanzapfung auf, um ein weiter verbessertes Signal - Rausch - Verhältnis zu erzielen.

Die Güte der Filterspule und die Güte der Kapazität, insbesondere eines Kondensators übersteigen die Güte der Aufnehmerspule und zwar wenigstens um das Doppelte, besonders bevorzugt wenigstens um das Dreifache. Die Güte der Aufnehmerspule ist gering und ist vorzugsweise kleiner als 30, vorzugsweise kleiner als 20, besonders bevorzugt kleiner als 10. Als Aufnehmerspule kann eine Zylinderspule, Oberflächenspule oder eine Sattelspule vorgesehen sein. Die Aufnehmerspule kann nur wenige Windungen aufweisen, beispielsweise bis zu 10 Windungen. Drähte oder Litzen von Aufnehmerspule und/oder Filterspule können beispielsweise aus Kupfer, Silber oder Gold bestehen.

Vorzugsweise umfasst die Vorrichtung und zwar insbesondere Aufnehmerspule und/ oder Filterspule Litzen, deren dünne Drähte elektrisch isoliert sind und zwar insbesondere durch isolierende Lackschichten, um so zu einem weiter verbesserten Signal - Rausch - Verhältnis zu gelangen. Vorhandene Litzen sind vorzugsweise hochfrequenzfest, um ein gutes Signal-Rausch-Verhältnis zu erhalten.

Die folgenden Ausgestaltungen verbessern einzeln sowie in beliebiger Kombination weiter das Signal - Rausch - Verhältnis:
Die Mittelanzapfung befindet sich vorzugsweise genau in der Mitte der Filterspule. Durch die Mittelanzapfung werden Schwingneigungen des Schwingkreises unterdrückt und zwar besonders gut, wenn die Mittelanzapfung genau mittig angeordnet ist. Dies wirkt sich positiv auf das Signal-Rausch-Verhältnis aus.

Die Mittelanzapfung ist in einer Ausgestaltung durch einen zusätzlichen Draht oder eine zusätzliche Litze realisiert. Ein Ende des zusätzlichen Drahts bzw. der zusätzlichen Litze ist mit Masse verbunden, also geerdet. Außerdem ist ein Ende des anderen Drahts der Filterspule mit Masse verbunden. Die gesuchte Spannung, also das gesuchte Nutzsignal liegt dann bei den verbleibenden Enden der Drähte bzw. Litzen an. Diese Ausgestaltung der Spule führt zu einer hohen Güte, die eine eigenständige Erfindung darstellt.

Zur Herstellung werden beispielsweise zwei elektrische Leiter (insbesondere erster und zweiter Draht oder erste und zweite Litze) miteinander verzwirbelt bzw. miteinander verdrillt. Anschließend werden die beiden miteinander verdrillten elektrischen Leiter zur Spule gewickelt. Das Ende des ersten elektrischen Leiters (Draht oder Litze) sowie das entgegengesetzte Ende des zweiten elektrischen Leiters (Draht oder Litze) werden dann geerdet. Die beiden anderen Enden bilden dann die elektrischen Anschlüsse der Spule.

Sind die vorgenannten beiden elektrischen Leiter gleich lang, so befindet sich die Mittelanzapfung exakt in der Mitte.

Die Filterspule ist insbesondere durch eine elektrische und/oder magnetische Abschirmung abgeschirmt. Wände der Abschirmung bestehen bei magnetischer Abschirmung vorzugsweise Mu-Metall oder Eisen, vorzugsweise hochpermeables Eisen.

Eine magnetische Abschirmung wird vorzugsweise durch eine im Wesentlichen magnetisch geschlossene Kammer oder geschlossene Dose gebildet.

Eine magnetische Abschirmung schützt vorteilhaft vor elektromagnetischen Störungen und trägt so zur Verbesserung des Signal - Rausch - Verhältnisses bei.

Wände der Abschirmung sind vorzugsweise doppelwandig ausgeführt oder innerhalb einer Dose befindet sich eine zweite Dose, die von der ersten Dose durch Abstandshalter auf Abstand gehalten wird. Innerhalb der zweiten Dose befindet sich dann die Filterspule. Die Abschirmung besteht daher besonders bevorzugt aus einer doppelwandigen Kammer oder doppelwandigen Dose.

Durch eine magnetische Abschirmung kann die Filterspule im Fall von NMR oder ESR - Spektroskopie magnetisch von einem magnetischen B₀ - Feld abgeschirmt werden, welches im Fall von NMR oder ESR eingesetzt wird. Diese Abschirmung bewirkt ein weiter verbessertes Signal-Rausch-Verhältnis.

Die Wände einer Doppelwand der magnetischen Abschirmung oder die Wände der ein oder zwei Dosen der magnetischen Abschirmung sind vorteilhaft 1 mm bis 3 mm dick, so zum Beispiel 1,5 mm dick. Wände einer elektrischen Abschirmung sind vorzugsweise bis zu 3 mm dick und/ oder wenigstens 0,5 mm dick. Wände einer elektrischen Abschirmung sind vorzugsweise geschlitzt. Wände einer elektrischen Abschirmung bestehen vorzugsweise aus Kupfer. Eine derart gestaltete elektrische Abschirmung trägt zu einem guten Signal - Rausch - Verhältnis bei.

Die Abschirmung ist vorzugsweise geerdet. Im Fall der zwei Dosen ist grundsätzlich die äußere Dose geerdet. Es kann aber auch alternativ oder ergänzend eine innere Dose geerdet sein.

Vorteilhaft ist die Aufnehmerspule von einer für NMR- oder ESR-Spektroskopie eingesetzten Anregungsspule getrennt. Es ist dann also eine zweite Spule vorhanden, die als Anregungsspule für die Durchführung von NMR- oder ESR- Spektroskopie eingesetzt wird. Hierdurch ist es möglich, die Messvorrichtung unabhängig von der Anregungsspule zu optimieren, was ein verbessertes Signal-Rausch-Verhältnis ermöglicht. Die Aufnehmerspule befindet sich vorzugsweise innerhalb der Anregungsspule. Der Abstand zwischen Anregungsspule und Aufnehmerspule beträgt vorteilhaft mindestens 5 mm, vorzugsweise wenigstens 10 mm, um eine nachteilhafte Kopplung zwischen den beiden Spulen hinreichend gering zu halten. Die Hauptachse der Anregungsspule (= Richtung rf - Feld) ist vorzugsweise im Wesentlichen senkrecht, vorzugsweise senkrecht, zur sensitiven Achse der Aufnehmerspule angeordnet, um eine nachteilhafte Kopplung zwischen den beiden Spulen hinreichend gering zu halten.

Aufnehmerspule einerseits und Kondensator nebst Filterspule andererseits sind in einer erfindungsgemäßen Ausgestaltung durch eine besonders verlustarme elektrische Transferleitung miteinander verbunden. Dies wird erreicht durch eine aus einem guten elektrischen Leiter bestehende Transferleitung, so zum Beispiel durch eine aus Kupfer bestehende Transferleitung, durch einen großen Querschnitt einer Transferleitung von zum Beispiel wenigstens 1 mm², durch eine Umschlingung bzw. Verzwirbelung der beiden elektrischen Leiter der Transferleitung und/oder durch eine geeignete elektrische Isolierung, insbesondere durch eine Isolierung aus Teflon. Jeder einzelne Leiter kann zwecks Isolierung sich in einer Teflonhülle befinden und/oder beide elektrischen Leiter der Transferleitung gemeinsam. Ein Leiter kann aus einem Draht oder einer Litze gebildet sein.

Eine Transferleitung ist vorzugsweise aus zwei miteinander verdrillten Litzen zu bilden, die vorzugsweise vorgenannte Teflonhüllen umfasst, um so eine besonders verlustarme Transferleitung für ESR- oder NMR-Spektroskopie bereit zu stellen, stellt eine eigenständige Erfindung dar. Ist die Transferleitung durch zwei Litzen gebildet, so bezieht sich der genannte Querschnitt von wenigstens 1 mm² auf die Summe der Querschnitte der Einzeldrähte der beiden Litzen und zwar einschließlich optional vorhandener Isolatoren. Litzen der Transferleitung sind wiederum vorzugsweise elektrisch voneinander isoliert und zwar insbesondere durch Lackoberflächenbeschichtung und/oder hochfrequenzfest ausgeführt, um eine verlustarme Transferleitung bereitzustellen, was zu einem weiter verbesserten Signal-Rausch-Verhältnis führt.

Die Aufnehmerspule ist vorzugsweise durch eine Litze gebildet, also aus einem aus dünnen Einzeldrähten bestehender elektrischer Leiter. Die Einzeldrähte der Litze sind vorteilhaft elektrisch voneinander isoliert. Die Oberflächen der Einzeldrähte sind daher vorteilhaft mit einem elektrisch isolierenden Lack versehen. Die Litze ist vorzugsweise hochfrequenzfest.

Als geeignet hat sich eine toroidale- oder zylinderförmige Filterspule mit Wicklung aus Litzendraht herausgestellt. Für die Realisierung eines externen Resonators mit hohen Güten Q_{E} > 1000 sollte die Filterspule einem magnetischen Wechselfeld mit möglichst kleinem Energieverlust folgen bzw. einen geringen AC-Verlust aufweisen. Dafür muss die Filterspule ein vernachlässigbares magnetisches Streufeld besitzen und der Wechselstromwiderstand der Wicklung sollte möglichst gering sein. Auch andere Verluste wie z.B. dielektrische Verluste oder Verluste in magnetischen Kern der Filterspule sollten minimiert sein.

Es resultiert eine Messvorrichtung, die als Bandpassfilter mit einem relativ schmalen Band wirkt. Bei entsprechender Abstimmung wird das Nutzsignal durchgelassen. Rauschsignale im angrenzenden Frequenzbereich werden herausgefiltert, so dass bereits deshalb ein gutes Signal - Rausch - Verhältnis erzielt wird. Vor allem aber gelingt eine geeignete Spannungsverstärkung, die maßgeblich zu einem guten Signal - Rausch - Verhältnis beiträgt.

Vorteilhaft beträgt der Abstand zwischen Aufnehmerspule einerseits und Kondensator nebst Filterspule andererseits wenigstens 5 cm, vorteilhaft wenigstens 50 cm, besonders vorteilhaft wenigstens 60 cm. Dies vermindert einen gegenseitigen störenden magnetischem Einfluss zwischen einem B₀ - Feld, wie es im Fall einer ESR- oder NMR - Spektroskopie vorhanden ist, und der in der Regel abgeschirmten Filterspule. Es wird erreicht, dass sich eine Abschirmung nicht nachteilhaft auf das B₀ - Feld auswirkt. Es wird weiter vermieden, dass die Abschirmung durch das B₀ - Feld nachteilhaft gesättigt wird.

Die Kapazität ist vorteilhaft abstimmbar, um eine geeignete Resonanz einstellen zu können. Vorteilhaft wird die Kapazität aus einer Vielzahl von einzelnen Kondensatoren gebildet, die geeignet parallel miteinander verschaltet sind sowie derart verschaltet werden können, um bei Bedarf die Kapazität verändern zu können. Es können so kommerziell erhältliche Kondensatoren mit hoher Güte eingesetzt werden, um eine abstimmbare Kapazität mit hoher Güte bereitzustellen. Vorteilhaft wird das Messsignal (also die an der Filterspule anliegende Spannung) verstärkt, beispielsweise zunächst durch einen rauscharmen Vorverstärker (bevorzugt durch einen Differenzenverstärker, besonders bevorzugt durch einen Instrumentenverstärker) und anschließend durch einen Endverstärker (bevorzugt durch einen Lock-in Verstärker).

Das erhaltene Signal-Rausch-Verhältnis im eingangs genannten Frequenzbereich kann mit dem Signal-Rausch-Verhältnis der Hochfeld NMR oder ESR (400 MHz - 1 GHz) konkurrieren. Der apparative Aufwand, der im eingangs genannten Frequenzbereich betrieben werden muss, ist jedoch vorteilhaft wesentlich geringer im Vergleich zur Hochfeld NMR bzw. ESR. Auch ist das Signal-Rausch-Verhältnis von der Frequenz nur schwach abhängig, so dass vor allem auch kleine Frequenzen möglich sind, was einen geringen technischen Aufwand möglich macht. Es sind vor allem auch kleine Probenvolumen möglich, ohne dass sich das Signal-Rausch-Verhältnis wesentlich verschlechtern würde.

Es kann sehr flexibel und robust im praktischen Einsatz gemessen werden. Die gesamte notwendige Hardware ist miniaturisierbar und erlaubt es, mobile ESR- oder NMR-Spektroskopie im Frequenzbereich von 1 kHz - 40 MHz mit Mikrospulen ohne den Einsatz von supraleitenden Magneten durchzuführen. Insbesondere kann eine ESR- oder NMR-Spektroskopie bei Frequenzen unterhalb 10 MHz und vor allem auch unterhalb von 1 MHz durchgeführt werden, um den apparativen Aufwand gering halten zu können. Anwendungsgebiete sind die chemische Analytik, die Sensortechnologie sowie Medizinwissenschaften.

Es zeigen:
- Figur 1:: Aufbau eines Ausführungsbeispiels
- Figur 2:: Miteinander verdrillte elektrische Leiter für Filterspule
- Figur 3:: Signal - Rausch - Verhältnis von 0.5 cm³ Benzol in Abhängigkeit der Anzahl der Windungen nl der Aufnehmer-bzw. Inputspule
- Figur 4:: Signal - Rausch - Verhältnis von Benzol in Abhängigkeit der Anzahl der Windungen nl der Aufnehmerspule unter Einsatz von Filterspulen mit Ferritkernen
- Figur 5:: Signal - Rausch - Verhältnis des ¹H-NMR Signals in Abhängigkeit des Volumens Vs einer Benzolprobe

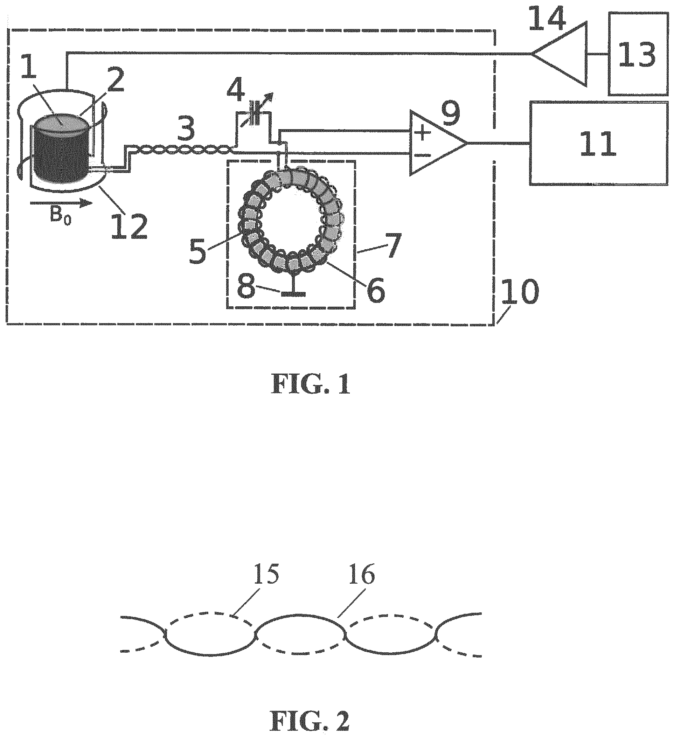

Nachfolgend wird eine bevorzugte Ausführungsform in der Figur. 1 dargestellt.

Eine um eine Probe 1 gewickelte Aufnehmerspule 2 beliebiger Bauform, ist über eine verlustarme Transferleitung 3 und einer abstimmbaren Kapazität 4 hoher Güte (Qc ∼ 10000) mit einer externen hochgütigen Filterspule 6 verbunden. Die Transferleitung umfasst zwei elektrische Leiter, die jeweils entweder aus einer mehradrigen Kupferleitung mit großem Querschnitt (> 1 mm²) und minimalen kapazitiven dielektrischen Verlusten aufgrund einer Teflon-Isolation bestehen oder aus dickem niederohmigen Litzendraht (1000 x 0.05 mm) mit vernachlässigbarem Skin- und Proximityeffekt bei Frequenzen unterhalb 1 MHz. Die beiden Leitungen sind wie dargestellt umeinander gewickelt, also miteinander verzwirbelt bzw. verdrillt. Im Fall einer Teflonisolation ist jeder Leiter von Teflon umhüllt. Zusätzlich befinden sich die beiden verzwirbelten bzw. miteinander verdrillten Leiter der Transferleitung 3 in einer Teflonhülle.

Das von der Aufnehmerspule aufgenommene oszillierende NMR-Signal (sog. freier Induktionszerfall, FID) wird über die Transferleitung 3 mit geringen Verlusten zur Filterspule 6 mit oder ohne Kern 5 geleitet. Wegen der hohen Güte Q_{E} der Filterspule wird das NMR-Signal gegenüber dem Rauschen um den reduzierten Faktor Q_{red} = Q_{E} /(1+R_{I}/R_{E}) >> 100 überhöht mit R_{I} = Wechselstromwiderstand der Aufnehmerspule und R_{E} = Wechselstromwiderstand der Filterspule. Die Wechselspannung an der Filterspule wird über zwei elektrisch leitende Verbindungen in den invertierenden und nichtinvertierenden Eingang eines Differenzenverstärkers 9 geleitet und dort weiter verstärkt. Um die Schwingneigung des sehr empfindlichen Resonators in Verbindung mit dem Differenzenverstärker 9 zu unterdrücken, ist eine geerdete Mittelanzapfung 8 an der Filterspule 6 vorhanden. Darüber hinaus sorgt die Mittelanzapfung 8 für die Ableitung der technisch unvermeidbaren Bias-Ströme des Differenzenverstärkers 9.

Die Filterspule 6 ist durch eine Abschirmung 7 gesondert magnetisch abgeschirmt.

Mögliche Ausführungsformen von Filterspulen mit einer Güte Q_{E} >> 100 sind z.B. speziell bewickelte verlustarme Ferritkerne, toroidale oder zylinderförmige Spulen mit Wicklung aus Litzendraht.

Vor allem bei der Verwendung von Ferriten besteht die Abschirmung 7 aus einer einfach-oder mehrfachen Mu-Metallabschirmung, die jegliche DC und/oder AC-Magnetfelder abschirmen. Andererseits soll die ihrerseits schwer magnetische Mu-Metall Abschirmung nicht die Homogenität des B₀ - Feldes beeinträchtigen. Dies wird durch einen genügend großen Abstand zwischen Probe 1 und der Mu-Metall Abschirmung 7 erreicht. Die Transferleitung 3 ist daher wenigstens ca. 10 - 50 cm lang.

Für toroidale oder zylinderförmige Filterspulen 6 ohne magnetischen Kern 5 wird eine elektrische Abschirmung 7 zum Beispiel aus Kupferblech eingesetzt, um elektromagnetische Störungen im interessierenden Frequenzbereich abzuschirmen. Die Abschirmung 7 besteht in diesem Fall in einer vorteilhaften Ausgestaltung aus elektrisch untereinander isolierten Teilabschnitten aus Kupfer und ist vorteilhaft so beschaffen, dass Wirbelströme vermieden werden, die das Q_{E} reduzieren könnten. Wirbelströme werden insbesondere durch geeignet angeordnete Schlitze vermieden.

Bei einer zylinderförmigen Filterspule 6 ohne magnetischen Kern 5 wäre z.B. der kritische Wirbelstrom der Abschirmung ein Kreisstrom um die zylindrische Achse der Filterspule 6, welcher das innere Magnetfeld der Filterspule 6 erheblich vermindert. Diese Kreisströme können nicht fließen, wenn die zylinderförmige Cu-Abschirmung, die die Filterspule 6 einschliesst, aus zwei Hälften besteht, die sich entlang des Mantels des Zylinders elektrisch nicht berühren. Weitere Schlitzungen der Abschirmung 7 um weitere Kreisströme auf der Oberfläche des Abschirmzylinders zu unterbinden, sind vorteilhaft im Sinne einer besseren Güte Q vorgesehen.

Der Differenzenverstärker 9 ist zwecks Optimierung des Signal - Rausch - Verhältnisses vorteilhaft so ausgelegt dass in dem betrachteten Frequenzbereich das Strom und Spannungsrauschen (iₙ, eₙ) geringer ist als das Johnson Eigenrauschen des Eingangskreises. Das verstärkte NMR Signal kann entweder über einen schnellen AD-Wandler direkt digital gesampelt werden oder aber analog über einen Lock-In Verstärker 11 weiterverarbeitet und über einen Computer analysiert werden. Das Analysesystem kann zwecks Verbesserung des Signal - Rausch - Verhältnisses mit einem Bandpassfilter ausgestattet sein.

Die Aufnehmerspule 2 kann je nach der Anwendung und den Umgebungsbedingungen eine Zylinder, Sattel- oder Oberflächenspule mit Dimensionen von 0.01- 10 cm sein. Dabei spielt die Güte und Form der Aufnehmerspule 2 für das Signal - Rausch - Verhältnis eine untergeordnete Rolle. Dies ist einer der großen Vorteile der vorliegenden Erfindung, die es erlaubt, Form und Design der Aufnehmerspule 2 völlig frei zu wählen. Dies ist wichtig für die Durchführbarkeit von NMR Untersuchungen unter erschwerten Bedingungen. Die Probe 1 mit den Kernspins befindet sich innerhalb oder auf der Oberfläche der entsprechenden Aufnehmerspule 2, je nachdem, ob es sich um eine Zylinder-, Sattelspule oder um eine Oberflächenspule handelt.

Eine Anregung der Kernspins erfolgt mittels einer größeren) Sattelspule 12 in Verbindung mit einem gepulsten Hochfrequenzgenerator 13 und einem Hochfrequenzverstärker 14. Die Sattelspule 12 ist zwecks minimaler Kopplung einerseits weit genug (∼ 1 cm) von der Aufnehmerspule 2 entfernt und andererseits ist die Hauptachse der Sattelspule (= Richtung rf-Feld) senkrecht zur sensitiven Achse der Aufnehmerspule 2 angeordnet.

Die Anregung der Probe 1 mit einem magnetischen Wechselfeld von der Sattelspule 12 ist praktisch völlig entkoppelt vom gesamten Empfangskreis. Deshalb muss der Empfangskreis nicht mehr auf eine bestimmte Impedanz abgestimmt werden und kann unabhängig von der Sendespule auf ein bestmögliches Signal - Rausch - Verhältnis-Verhältnis optimiert werden. Die Probe 1 befindet sich in dem homogenen Magnetfeldbereich B₀ eines nicht dargestellten Elektro- oder Hallbachmagneten, die typische Feldstärken im Bereich von B₀ = 10⁻⁴ T - 1 T erzeugen können. Dieser Feldbereich entspricht für Protonen einem Bereich der Larmorfrequenzen von f = 4 kHz - 42 MHz. Die Komponenten 1 bis 9 sind elektrisch zweifach abgeschirmt mittels zweier ineinander geschachtelter Kupfer und/oder Aluminium Schilde 10.

Der Sendekreis ist bei dem in Figur 1 dargestellten Ausführungsbeispiel vom Empfangskreis entkoppelt. Der Empfangskreis ist räumlich separiert in einen Bereich der Signalaufnahme (Aufnehmerspule 2 mit Probe 1) und einen externen Resonator hoher Güte. Die Entkopplung des Sendevom Empfangskreis erlaubt es, den Empfangskreis separat zu optimieren ohne Berücksichtigung einer Impedanzanpassung zwischen Sende- und Empfangskreis. Insbesondere kann der Empfangskreis vorteilhaft z.B. mehrere MOhm Impedanz haben, was der Fall insbesondere bei Parallelschwingkreisen mit sehr hoher Güte ist. Wegen der zweiten Bedingung kann die Aufnehmerspule unabhängig von allen anderen Elementen frei gestaltet werden und braucht keine hohe Güte zu besitzen. Der externe Resonator kann auf höchste Güte und damit auf maximale Verstärkung des NMR-Signals optimiert werden.

In der Figur 2 werden zwei miteinander verdrillte elektrische Leiter 15 und 16 gezeigt, wie sie für die Transferleitung 3 oder für die Filterspule 6 eingesetzt sein können. Im Fall der Filterspule 6 werden die verdrillten Drähte 15 und 16 gemeinsam zur Spule gewickelt. Ein Ende des einen elektrischen Leiters 15, so zum Beispiel das in der Figur 2 links gezeigte Ende, und das gegenüberliegende Ende des Leiters 16, also dann das rechts gezeigte Ende, werden elektrisch miteinander verbunden und bilden so die Mittelanzapfung 8, die geerdet wird. Die verbleibenden Enden der elektrischen Leiter 15 und 16 werden dann mit dem vorzugsweise abstimmbaren Kondensator 4 einerseits und einem elektrischen Leiter der Transferleitung 3 andererseits elektrisch verbunden.

Eine Filterspule 6 mit Ferritkern 5 hat den großen Vorteil, das sie relativ klein und preisgünstig ist und Güten bis zu Q_{E} ∼ 500 realisierbar sind. Ferritkerne erhält man im Handel in verschiedenen Größen und Bauformen, z.B. als Toroide oder in geschlossenen Formen (Topfkreis) um die magnetischen Streuverluste so gering wie möglich zu halten.

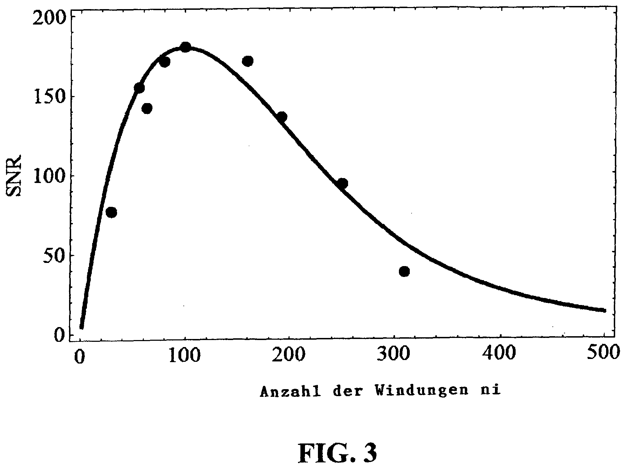

Zwei verflochtene Kupferdrähte gleicher Länge werden in einer Ausgestaltung mit wenigen Windungen um den Ferritkern gewickelt, wobei die Zahl der Windungen n_{E} von der Detektionsfrequenz abhängt, typischerweise von n_{E} = 8 bei 8 bis 500 kHz bis zu n_{E} = 104 bei 20 kHz. Das verflochtene Windungspaar aus mehradrigem Kupfer oder Litzendraht minimiert den Skin- und Proximityeffekt und den damit verbundenen AC-Widerstand erheblich. Eine Mittelanzapfung 8 ist genau in der Mitte zwischen beiden verflochtenen Wicklungshälften herausgeführt. Diese verhindert bei Erdung eine mögliche Schwingneigung des hochgütigen Gesamtkreises. Alle Filterspulen mit Ferritkernen reagieren extrem empfindlich auf äußere magnetische und elektromagnetische Felder und werden deshalb bevorzugt mit einer magnetischen Zweifach Abschirmung aus Mu-Metall (Abschirmfaktor ∼ 1000) abgeschirmt. Da die beiden Mu-Metall Schirme auch elektrisch leitfähig sind, schirmen sie neben Magnetfeldern auch vor elektromagnetischen Wechselfeldern ab. Es wurden verschiedene Filterspulen mit Ferritkernen bei fünf verschiedenen Frequenzen gebaut mit folgenden Güten: Q_{E} = 218 bei 500 kHz, Q_{E} = 380 bei 166 kHz, Q_{E} = 369 bei 83 kHz, Q_{E} = 280 bei 41 kHz und Q_{E} = 255 bei 20 kHz. Der AC-Widerstand, die Induktivität, Kapazität bzw. die Güte aller Filterspulen sowie aller relevanten Bauelemente wie Transferleitung und Abstimmkondensatoren wurden mit einem Impedanzspektrometer als Funktion der Frequenz vermessen und optimiert. Es wurden Protonen (¹H) Experimente mit allen fünf Ferriten mit einer vorpolarisierten Benzol Probe (Vₛ ∼ 0.3 cm³, Nₛ = 2 x 10²² Protonen, Pₙ ∼ 1.5 x 10⁻⁶) durchgeführt. Die Aufnehmerspule 2 war gekennzeichnet durch die Parameter Di = H_{c} = 1 cm, W_{I} = 63, dcu = 0.12 mm, und durch ihre gesamte Windungszahl n_{I}. Das gemessene Signal - Rausch - Verhältnis (SNR) in Abhängigkeit von n_{I} für die Filterspule mit Ferrit bei 500 kHz ist in der Figur 3 dargestellt. Die Messpunkte (schwarze Kreise) sind in guter Übereinstimmung mit der theoretischen Erwartung (durchgezogene Linie). Die Parameter für den Ferritkern bei 500 kHz sind: L_{E} = 116 µH, R_{E} = 1.77 Ohm und Q_{E} = 218. Figur 3 zeigt deutlich den zunächst linearen Anstieg des Signal - Rausch - Verhältnis mit n_{I}, dann ein Maximum bei n_{I}^{max} ∼ 90-100 mit Signal - Rausch - Verhältnis = 170, und schließlich den hyperbolischen Abfall, der in Einklang ist mit einem dominierenden Skineffekt und sehr schwachen Proximityeffekt (∼ 3 % vom Skineffekt).

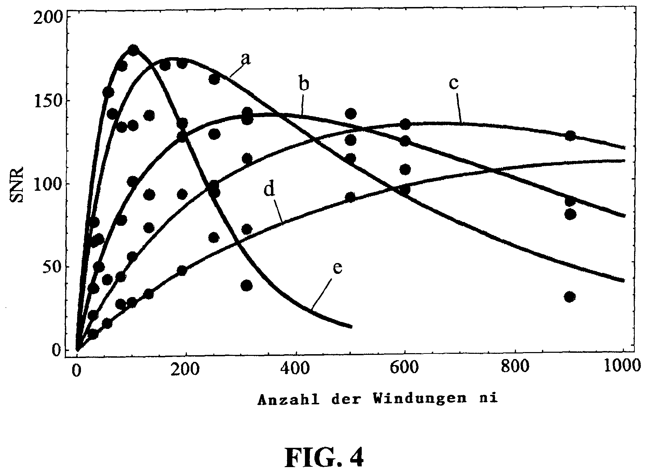

Figur 4 zeigt das Signal - Rausch - Verhältnis von Benzol in Abhängigkeit der Anzahl der Windungenl nl der Aufnehmerspule unter Einsatz von Filterspulen mit Ferritkernen und nach Vorpolarisation auf Pn = 1.5x10⁻⁶. Kreise stellen gemessene Werte dar und durchgezogene Linien entsprechen dem erwarteten Verlauf. Die Frequenzen f (und Güten QE) betragen 500 kHz (QE = 218, e), 166 kHz (QE = 280, a), 83 kHz (QE = 369, b), 41 kHz (QE = 380, c) und 20 kHz (QE = 250, d). Die Parameter der Filterspule sind gleich wie in Figur 3. Figur 4 bestätigt anhand von experimentellen Ergebnissen, die bei den fünf verschiedenen Frequenzen 500, 166, 83, 41 und 20 kHz gemessen wurden, dass bei konstanter Güte der Filterspule das Signal-Rausch-Verhältnis sehr schwach von der Frequenz abhängt. Bei Erniedrigung der Frequenz f verschiebt sich das gemessene Maximum des Signal - Rausch - Verhältnis zu größeren Werten von n_{I}. Aus den Maxima der fünf Kurven kann man die Windungszahl n_{I}^{max} ablesen: n_{I}^{max} = 90, 140, 350, 750 für f = 500, 166, 83, und 41 kHz. Das wichtigste Ergebnis aus Figur 4 ist, dass das maximale Signal - Rausch - Verhältnis sehr schwach mit der Frequenz abnimmt. Dies bedeutet, dass Messungen mit Ferritkernen im gesamten Frequenzbereich von einigen kHz (NMR im Erdmagnetfeld) bis zu etlichen MHz mit großem Signal - Rausch - Verhältnis durchgeführt werden können.

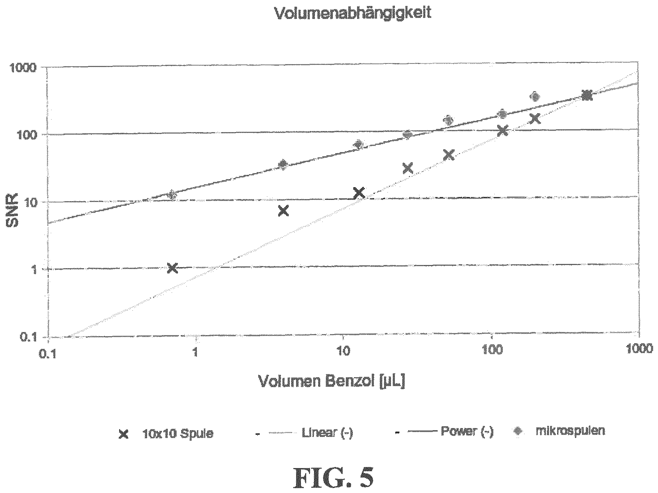

Figur 5 zeigt das Signal - Rausch - Verhältnis des ¹H-NMR Signals in Abhängigkeit des Volumens Vs einer Benzolprobe. Gemessen wurde nach Vorpolarisation auf Pₙ = 1.5x10⁻⁶ bei 500 kHz mit einer Filterspule mit Ferritkern mit QE = 218. Die Kreuze entsprechen Messungen, die alle mit der gleichen Inputspule (Di = Hc = 1 cm) aber mit verschiedenen Probenvolumina (0.7 - 500 µL), durchgeführt wurden. Die Rauten entsprechen Messungen, bei der Inputspule und Probe zusammen um denselben Faktor geschrumpft sind (1 mm < Di = Hc < 1 cm). Die Geraden entsprechen dem erwarteten Verlauf.

Figur 5 verdeutlicht anhand von zwei ¹H- NMR Experimenten von Benzol, wie das Signal - Rausch - Verhältnis mit dem Volumen der Probe skaliert. Beim ersten Experiment wurde das Signal - Rausch - Verhältnis bei 500 kHz mit einer Filterspule mit Ferritkern (Q_{E} = 218) und mit einer fest vorgegebenen Aufnehmerspule (Parameter: Dᵢ = H_{c} = 1 cm, n_{I} = 160, dcu = 0.12 mm), aber mit verschiedenen Probenvolumina Vₛ (von 0.7 bis 500 µL) gemessen. Beim zweiten Experiment wurde entsprechend mit dem schrumpfenden Volumen der Probe auch das Volumen bzw. der Innendurchmesser Dᵢ und die Höhe H_{c} der Aufnehmerspule verkleinert, von Dᵢ = H_{c} = 1 cm auf Dᵢ = H_{c} = 0.1 cm. Die Windungszahl nᵢ = 80 wurde dabei konstant gehalten. Man sieht in Figur 5, dass das gemessene Signal - Rausch - Verhältnis im ersten Fall mit Signal - Rausch - Verhältnis ∼ Nₛ ∼ Vₛ und im zweiten Fall mit Signal - Rausch - Verhältnis ∼ Nₛ^{1/2} ∼ Vₛ^{1/2} skaliert (N₅ = Zahl der Spins). Diese schwache Volumenabhängigkeit im zweiten Fall kann man auf die zunehmende Sensitivität ∼ 1/Dᵢ der immer kleiner werden Aufnehmerspule zurückführen. Dieses Ergebnis zeigt, dass mit dem Verfahren Mikrospulen detektierte NMR-Spektroskopie bei niedrigen Frequenzen und mit µL großen Proben möglich ist. Dies ist im Hinblick auf eine Miniaturisierung von mobilen NMR-Spektrometern ein wichtiges Ergebnis. Bei Frequenzen unterhalb 10 MHz und für sehr kleine Proben kann der Magnet, der das B-Feld erzeugt, sehr klein, portabel, energie- und kosteneffizient gebaut sein. Energieeffizienz bedeutet z.B. dass eine Lithium-Ionen Batterie ausreicht, um einen kleinen Elektromagneten mit Strom zu versorgen. Kosteneffizienz zeigt sich u.a. auch bei miniaturisierten Permanentmagneten, die für ihren Bau eine vergleichsweise viel geringere Menge an magnetischen Material (seltene Erden) benötigen.

An dieser Stelle sei noch erwähnt dass die gemessene Skalierung Signal - Rausch - Verhältnis ∼ Vₛ^{1/2} nur für eine konstant gehaltene Windungszahl n_{I} gilt.

## Patentansprüche

1. Messvorrichtung zur Detektion elektromagnetischer oder magnetischer Wechselfelder mit einem elektromagnetischen Schwingkreis mit einer Aufnehmerspule (2), die für das Detektieren der Wechselfelder eingerichtet ist und die keine hohe Güte aufweist, einer vorzugsweise abstimmbaren Kapazität (4) und einer Filterspule (6), wobei Aufnehmerspule (2), Kapazität (4) und Filterspule (6) Teile des gleichen Schwingkreises sind, mit einer verlustarmen Transferleitung (3), die die Aufnehmerspule mit der Filterspule (6) und der Kapazität 4 verbindet, so dass die Anordnung dazu eingerichtet ist, das von der Aufnehmerspule (2) aufgenommene Signal über die Transferleitung (3) zur Filterspule (6) zu leiten, wobei die Anordnung dazu eingerichtet ist, das an die Filterspule geleitete Signal an einen Differenzverstärker (9) zu leiten, **dadurch gekennzeichnet, dass** Kapazität (4) und Filterspule (6) eine hohe Güte größer als 100, vorteilhaft größer 200, besonders bevorzugt größer als 500 aufweisen und/oder der Schwingkreis eine hohe Güte größer als 100, vorteilhaft größer 200, besonders bevorzugt größer als 500 aufweist und wobei die Güte der Filterspule (6) und die Güte der Kapazität (4) die Güte der Aufnehmerspule (2) übersteigen und zwar wenigstens um das Doppelte, wobei die Filterspule (6) des Schwingkreises eine geerdete Mittelanzapfung (8) umfasst.

2. Vorrichtung nach Anspruch 1, **dadurch gekennzeichnet, dass** die Filterspule (6) zwei miteinander verdrillte elektrische Leiter umfasst, die zur Spule gewickelt sind, wobei jeweils ein Ende eines jeden Leiters geerdet ist.

3. Vorrichtung nach einem der vorhergehenden Ansprüche, **dadurch gekennzeichnet, dass** die Filterspule (6) einen magnetischen Kern (5) aufweist, der insbesondere aus Ferrit besteht.

4. Vorrichtung nach einem der vorhergehenden Ansprüche, **dadurch gekennzeichnet, dass** die Filterspule (6) magnetisch und/oder elektrisch durch eine Abschirmung (7) abgeschirmt ist.

5. Vorrichtung nach dem vorhergehenden Anspruch, **dadurch gekennzeichnet, dass** die Abschirmung (7) doppelwandig ist.

6. Vorrichtung nach einem der beiden vorhergehenden Ansprüche, **dadurch gekennzeichnet, dass** der Abstand zwischen der Abschirmung (7) und der Aufnehmerspule (2) wenigstens 1 cm, vorzugsweise wenigstens 5 cm, besonders bevorzugt wenigstens 50 cm beträgt.

7. Vorrichtung nach einem der vorhergehenden Ansprüche, **gekennzeichnet durch** die Transferleitung (3) zwischen Aufnehmerspule (2) und Kondensator nebst Filterspule (6), die aus zwei umeinander gewickelten elektrischen Leitern besteht und/oder deren Leitungen insgesamt einen Querschnitt von wenigstens 1 mm² aufweisen und/oder deren Leitungen aus Kupfer, insbesondere Kupferlitzen, bestehen und/oder die mit Teflon umhüllt sind.

8. Vorrichtung nach einem der vorhergehenden Ansprüche, **gekennzeichnet durch** eine Anregungsspule (12) für die Durchführung von ESR- oder NMR Spektroskopie, die insbesondere von der Aufnehmerspule (2) getrennt ist.

9. Vorrichtung nach einem der vorhergehenden Ansprüche, **dadurch gekennzeichnet, dass** die Kapazität (4) durch eine Mehrzahl von parallel geschalteten Einzelkondensatoren gebildet ist.

10. Vorrichtung nach einem der vorhergehenden Ansprüche, **dadurch gekennzeichnet, dass** der Differenzverstärker (9), insbesondere ein Instrumentenverstärker, die an der Filterspule (6) anliegende Spannung zu verstärken vermag.

11. Vorrichtung nach dem vorhergehenden Anspruch, **dadurch gekennzeichnet, dass** der Differenzverstärker hochohmig ist und zwar größer als 10⁶ Ohm.

12. Vorrichtung nach einem der vorhergehenden Ansprüche, **gekennzeichnet durch** eine äußere Abschirmung (10), in der sich der elektrische Schwingkreis umfassend die Aufnehmerspule (2), die Kapazität (4) und die Filterspule (6) befinden und darüber hinaus insbesondere auch eine Anregungsspule (12), eine Transferleitung (3) und/ oder ein Verstärker (9).

13. Verfahren für das Detektieren von schwachen elektromagnetischen Signalen einer Probe (1) mit einer Messvorrichtung nach einem der vorhergehenden Ansprüche, **dadurch gekennzeichnet, dass** die Probe (1) innerhalb oder auf der Oberfläche der Aufnehmerspule (2) angeordnet ist, sich die Probe (1) in einem statischen magnetischen Feld (Bo) befindet, und die Probe (1) durch eine Spule (12) angeregt wird, die von der Aufnehmerspule (2) getrennt ist.

14. Verfahren nach dem vorhergehenden Anspruch, bei dem ein Signal mit einer Frequenz von 1 kHz bis 40 MHz, vorzugsweise bis 1 MHz, gemessen wird.

## Claims

1. Measuring device for the detection of alternating electromagnetic or magnetic fields with an electromagnetic oscillating circuit with a pick-up coil (2) which is adapted for the detection of the alternating fields and which does not have a high Q factor, a preferably tunable capacitance (4) and a filter coil (6), wherein pick-up coil (2), capacitance (4) and filter coil (6) are parts of the same oscillating circuit, with a low-loss transfer line (3) connecting the pick-up coil to the filter coil (6) and the capacitance (4), so that the assembly is arranged to conduct the signal picked up by the pick-up coil (2) via the transfer line (3) to the filter coil (6), wherein the assembly is adapted to conduct the signal conducted to the filter coil to a differential amplifier (9), **characterized in that** the capacitance (4) and the filter coil (6) have a high Q factor greater than 100, advantageously greater than 200, particularly preferably greater than 500 and/or the oscillating circuit has a high Q factor greater than 100, advantageously greater than 200, particularly preferably greater than 500 and wherein the Q factor of the filter coil (6) and the Q factor of the capacitance (4) exceed the Q factor of the pick-up coil (2), namely by at least twice, wherein the filter coil (6) of the oscillating circuit comprises a grounded center tap (8)

2. Device according to one of the preceding claims, **characterized in that** the filter coil (6) comprises two electrical conductors twisted together and wound to form the coil, wherein one end, respectively, of each conductor is grounded.

3. Device according to one of the preceding claims, **characterized in that** the filter coil (6) comprises a magnetic core (5) which, in particular, consists of ferrite.

4. Device according to one of the preceding claims, **characterized in that** the filter coil (6) is magnetically and/or electrically shielded by a shielding (7).

5. Device according to the preceding claim, **characterized in that** the shielding (7) is double-walled.

6. Device according to one of the two preceding claims, **characterized in that** the distance between the shielding (7) and the pick-up coil (2) is at least 1 cm, preferably at least 5 cm, particularly preferably at least 50 cm.

7. Device according to one of the preceding claims, **characterized by** the transfer line (3) between pick-up coil (2) and capacitor together with filter coil (6), which consists of two electrical conductors wound around one another and/or the lines of which have a total cross-section of at least 1 mm² and/or the lines of which consist of copper, in particular copper strands, and/or which are sheathed with Teflon.

8. Device according to one of the preceding claims, **characterized by** an excitation coil (12) for performing EPR or NMR spectroscopy, which is in particular separated from the pick-up coil (2).

9. Device according to one of the preceding claims, **characterized in that** the capacitance (4) is formed by a plurality of individual capacitors connected in parallel.

10. Device according to one of the preceding claims, **characterized in that** the differential amplifier (9), in particular an instrumentation amplifier, is capable of amplifying the voltage present at the filter coil (6).

11. Device according to the preceding claim, **characterized in that** the differential amplifier has a high impedance, namely greater than 10⁶ Ohm.

12. Device according to one of the preceding claims, **characterized by** an outer shielding (10) in which the electric oscillating circuit comprising the pick-up coil (2), the capacitance (4) and the filter coil (6) is located and in addition in particular also an excitation coil (12), a transfer line (3) and/or an amplifier (9).

13. Method for the detection of weak electromagnetic signals of a sample (1) with a measuring device according to one of the preceding claims, **characterized in that** the sample (1) is placed inside or on the surface of the pick-up coil (2), the sample (1) is in a static magnetic field (B0), and the sample (1) is excited by a coil (12) which is separated from the pick-up coil (2).

14. Method according to the preceding claim, in which a signal with a frequency of 1 kHz to 40 MHz, preferably to 1 MHz, is measured.

## Revendications

1. Dispositif de mesure pour la détection de champs alternatifs électromagnétiques ou magnétiques avec un circuit oscillateur électromagnétique, comprenant une bobine de détection (2), qui est adaptée pour détecter les champs alternatifs et qui ne comprend pas de grande qualité, une capacité (4) de préférence accordable et une bobine de filtrage (6), dans lequel la bobine de détection (2), la capacité (4) et la bobine de filtrage (6) font parti du même circuit oscillateur, comprenant un conduit de transfert à faible perte (3), qui relie la bobine de détection à la bobine de filtrage (6) et à la capacité (4), de sorte que l'ensemble est adapté à transmettre le signal reçu par la bobine de détection (2) via le conduit de transfert (3) à la bobine de filtrage (6), dans lequel l'ensemble est adapté à transmettre le signal transmis à la bobine de filtrage à un amplificateur différentiel (9), **caractérisé en ce que** la capacité (4) et la bobine de filtrage (6) comprennent une qualité élevée supérieure à 100, de préférence supérieure à 200, de préférence particulière supérieure à 500, et/ou le circuit oscillateur comprend une qualité élevée supérieure à 100, de préférence supérieure à 200, de préférence particulière supérieure à 500, et dans lequel la qualité de la bobine de filtrage (6) et la qualité de la capacité (4) excèdent la qualité de la bobine de détection (2), à savoir au moins du double, la bobine de filtrage (6) du circuit oscillateur comprenant une prise centrale mise à la masse.

2. Dispositif selon la revendication 1, **caractérisé en ce que** la bobine de filtrage (6) comprend deux conducteurs électriques torsadés ensemble, qui sont enroulés vers la bobine, respectivement une extrémité de chaque conducteur étant mise à la masse.

3. Dispositif selon l'une des revendications précédentes, **caractérisé en ce que** la bobine de filtrage (6) comprend un noyau magnétique (5), qui consiste notamment en ferrite.

4. Dispositif selon l'une des revendications précédentes, **caractérisé en ce que** la bobine de filtrage (6) est blindée magnétiquement et/ou électriquement par un blindage (7).

5. Dispositif selon la revendication précédente, caractérisé en que le blindage (7) a une double paroi.

6. Dispositif selon l'une des deux revendications précédentes, **caractérisé en ce que** la distance entre le blindage (7) et la bobine de détection (2) est au moins 1 cm, de préférence au moins 5 cm, de préférence particulière au moins 50 cm.

7. Dispositif selon l'une des revendications précédentes, **caractérisé par** le conduit de transfert (3) entre la bobine de détection (2) et le condensateur avec la bobine de filtrage (6), le conduit de transfert consistant en deux conducteurs électriques enroulés l'un autour de l'autre et/ou dont les conduites comprennent dans l'ensemble une section transversale d'au moins 1 mm² et/ou dont les conduites sont fabriquées en cuivre, notamment en âmes de cuivre, et/ou qui sont enveloppées de Téflon.

8. Dispositif selon l'une des revendications précédentes, **caractérisé par** une bobine d'excitation (12) pour effectuer la spectroscopie ESR ou MMR, laquelle bobine d'excitation est notamment séparée de la bobine de détection (2).

9. Dispositif selon l'une des revendications précédentes, **caractérisé en ce que** la capacité (4) est formée par une pluralité de condensateurs individuels connectés en parallèle.

10. Dispositif selon l'une des revendications précédentes, **caractérisé en ce que** l'amplificateur différentiel (9), notamment un amplificateur de mesure, est capable d'amplifier la tension appliquée à la bobine de filtrage (6).

11. Dispositif selon la revendication précédente, **caractérisé en ce que** l'amplificateur différentiel a une grande valeur ohmique, à savoir supérieure à 10⁶ Ohm.

12. Dispositif selon l'une des revendications précédentes, **caractérisé par** un blindage extérieur (10), dans lequel se trouvent le circuit oscillateur électrique comprenant la bobine de détection (2), la capacité (4) et la bobine de filtrage (6) et en outre notamment aussi une bobine d'excitation (12), un conduit de transfert (3) et/ou un amplificateur (9).

13. Procédé destiné à la détection de signaux électromagnétiques faibles d'un échantillon (1) par un dispositif de mesure selon l'une des revendications précédentes, **caractérisé en ce que** l'échantillon (1) est disposé à l'intérieur ou sur la surface de la bobine de détection (2), l'échantillon se trouve dans un champ magnétique statique (B₀), et l'échantillon est excité par une bobine (12), qui est séparée de la bobine de détection (2).

14. Procédé selon la revendication précédente, dans lequel un signal ayant une fréquence comprise entre 1 kHz et 40 MHz, de préférence jusqu'à 1 MHz, est mesuré.
